# EUROPEAN PATENT APPLICATION

(11) **EP 2 413 682 A2**
(43) Date of publication of application: **01.02.2012**
(21) Application number: 11175301.8
(22) Date of filing: 26.07.2011
(51) Int. Cl.: H05K 9/00

(54) **High frequency apparatus and printed board holding structure**

(30) Priority: 28.07.2010 JP 2010169283
(71) Applicant: Mitsumi Electric Co., Ltd., Tama-shi, Tokyo 206-8567 (JP)
(72) Inventor: Kishiue, Yoshifumi, Tokyo, 206-8567 (JP)
(74) Representative: Kopf, Korbinian Paul

(57) **Abstract**

A structure having a printed board in which an electronic circuit is formed and a case having a top plate and side plates and holding the printed board, has an engagement claw formed by using a part of the top plate; and a through hole formed in the printed board, an extending end part of the engagement claw being inserted into the through hole and passing through the printed board. The engagement claw and the through hole are fixed together by using a solder.

## Description

### BACKGROUND OF TEE INVENTION

### 1. Field of the Invention

The present invention relates to a high frequency apparatus having a printed board in which an electronic circuit is formed, and a case having a top plate and side plates and holding the printed board. It is noted that a high frequency apparatus means an apparatus that processes a high frequency signal, and examples of a high frequency apparatus are a high-frequency amplifier and a high-frequency tuner apparatus. The present invention also relates to a printed board holding structure having a printed board in which an electronic circuit is formed, and a case having a top plate and side plates and holding the printed board.

### 2. Description of the Related Art

For example, a high frequency apparatus or such has a structure such that a printed board in which an electronic circuit is formed is held by a frame-shaped case. For example, Japanese Laid-Open Patent Application 2006-245497 discloses a high frequency module having a structure such that a frame-shaped shield case is mounted on a circuit board.

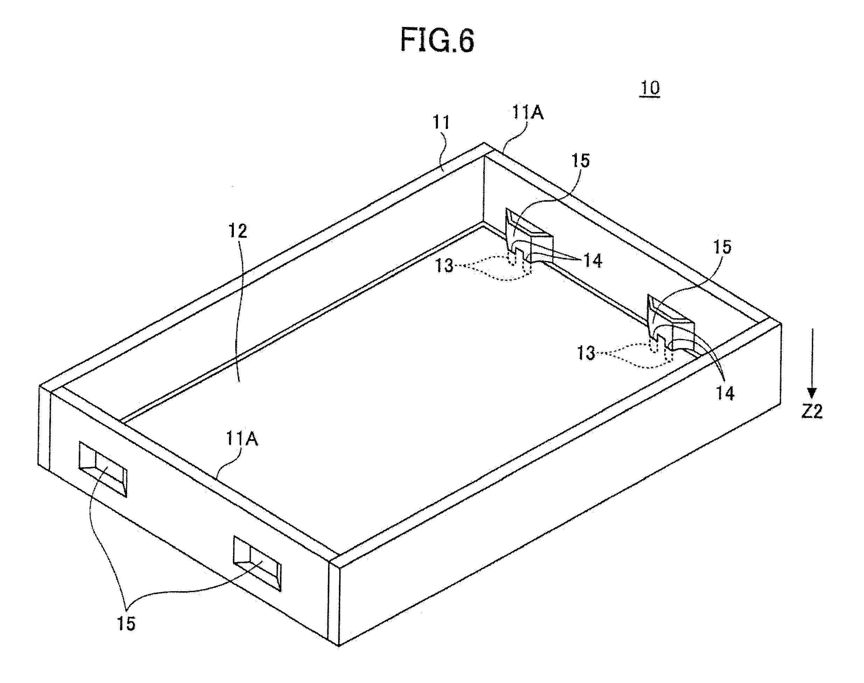

FIG. 6 illustrates a structure of holding a printed board in a high frequency apparatus according to the related art.

The high frequency apparatus according to the related art has a printed board holding structure 10 as shown in FIG. 6. The printed board holding structure 10 has a frame-shaped case 11 and a printed board 12, and the case 11 holds the printed board 12. The case 11 is made of a metal, and has a shielding function. The shielding function includes at least one of an electrostatic shielding function, a magnetic shielding function and an electromagnetic shielding function. In the printed board holding structure 10, the case 11 and the printed board 12 are soldered together, and thus, the printed board 12 is held by the case 11.

The case 11 has engagement claws 13 formed as members to be used when the printed board 12 and the case 11 are soldered together. The printed board 12 has through holes 14 through which the engagement claws 13 are to pass. The engagement claws 13 are formed as follows. That is, recesses 15 are formed from side plates 11A toward the inside of the case 11, and the engagement claws 13 are formed from the recesses 15 to extend in a Z2 direction toward the printed board 12, as sown in FIG. 6.

In the configuration of FIG. 6, the recesses 15 are provided on the side plates 11A of the case 11 in order to provide the engagement claws 13. For this purpose, certain spaces are required in the inside of the case 11. Therefore, it is not possible to form circuit patterns and/or interconnection patterns of an electronic circuit on the printed board 12 at areas corresponding to the above-mentioned spaces for the recesses 15. Thus, the area on the printed board 12 may not be effectively used, and miniaturization of the high frequency apparatus may be obstructed.

Further, spaces on the printed board 12 near the four corners may be dead spaces such that it is not possible to form circuit patterns and/or interconnection patterns of the electronic circuit. It is preferable to effectively use the dead spaces. However, the dead spaces on the printed board 12 cannot be used in the configuration of FIG. 6 for connecting the case 11 and the printed board 12. This is because from the viewpoints of manufacturing and strength of the case 11, it may be difficult to provide the recesses 15 above the spaces on the printed board 12 near the four corners. Therefore, also from this point, the area on the printed board 12 may not be effectively used, and miniaturization of the high frequency apparatus may be obstructed.

### SUMMARY OF THE INVENTION

An embodiment of the present invention has been devised for the purpose of solving the above-mentioned problem. In the embodiment of the present invention, restrictions on places to dispose engagement claws for fixing a printed board and a case together are eliminated, and thus, the area on the printed board can be used effectively. Thus, the embodiment of the present invention provides a high frequency apparatus and a printed board holding structure such that the entirety of the apparatus or the structure can be miniaturized.

The high frequency apparatus according to the embodiment of the present invention has a printed board in which an electronic circuit is formed; and a case having a top plate and side plates, and holding the printed board. The high frequency apparatus further has an engagement claw formed by using a part of the top plate, and a through hole formed in the printed board. The through hole is formed in such a manner that an extending end part of the engagement claw is inserted into and passes through the through hole. In the high frequency apparatus, the engagement claw and the through hole are fixed together by using solder.

The printed board holding structure according to the embodiment of the present invention has a printed board in which an electronic circuit is formed; and a case having a top plate and side plates, and holding the printed board. The high frequency apparatus further has an engagement claw formed by using a part of the top plate, and a through hole formed in the printed board. The through hole is formed in such a manner that an extending end part of the engagement claw is inserted into and passes through the through hole. In the high frequency apparatus, the engagement claw and the through hole are fixed together by using solder.

### BRIEF DESCRIPTION OF THE DRAWINGS

FIG. 1 shows a perspective view illustrating a high frequency apparatus or a printed board holding structure according to a first embodiment of the present invention;
FIG. 2A shows a view taken from a Z1 direction in FIG. 1 illustrating the high frequency apparatus or the printed board holding structure according to the first embodiment of the present invention;
FIG. 2B shows a view illustrating an engagement claw in the high frequency apparatus or the printed board holding structure according to the first embodiment of the present invention;
FIG. 3 shows a perspective view illustrating a high frequency apparatus or a printed board holding structure according to a second embodiment of the present invention;
FIG. 4A shows a developed view illustrating an engagement claw in the high frequency apparatus or the printed board holding structure according to the second embodiment of the present invention;
FIG. 4B shows a view taken from a Y2 direction in FIG. 3 illustrating the high frequency apparatus or the printed board holding structure according to the second embodiment of the present invention;
FIG. 4C shows a view taken from a Z1 direction in FIG. 3 illustrating the high frequency apparatus or the printed board holding structure according to the second embodiment of the present invention;
FIGS. 5A and 5B show views illustrating engagement between a case and a printed board in the high frequency apparatus or the printed board holding structure according to the second embodiment of the present invention; and
FIG. 6 shows a perspective view illustrating a structure of holding a printed board in a high frequency apparatus according to the related art.

Other objects and further features of embodiments of the present invention will become more apparent from the following detailed description when read in conjunction with the following accompanying drawings:

### DETAILED DESCRIPTION OF THE EMBODIMENTS

According to embodiments of the present invention, by using at least part of a top plate of a case that holds a printed board, engagement claws are formed having extending end parts for fixing the printed board and the case together. As a result, it is possible to dispose the extending end parts of the engagement claws at any positions on the printed board, and thus, it is possible to eliminate restrictions on positions to dispose the extending end parts of the engagement claws.

### (First Embodiment)

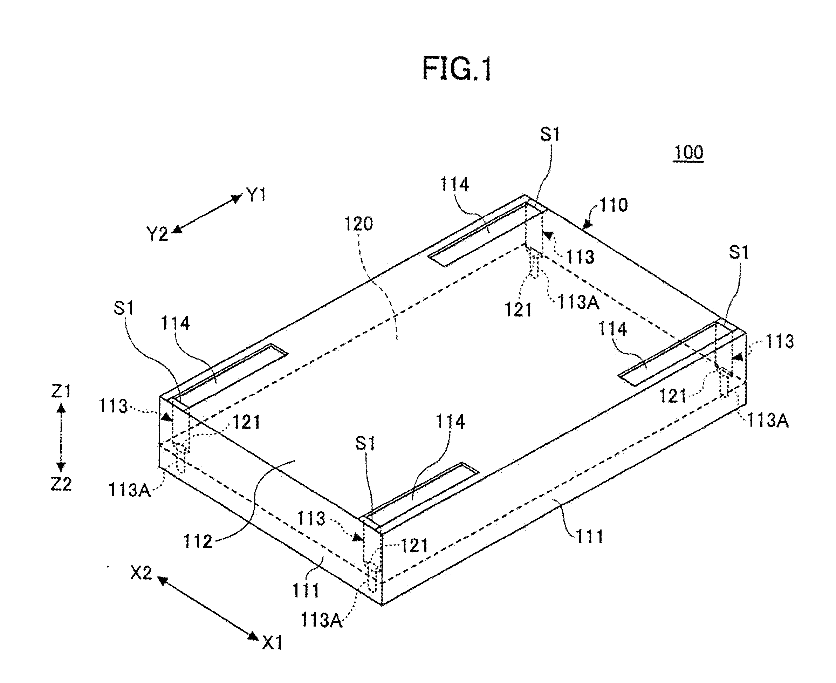

Below, with reference to figures, a first embodiment of the present invention will be described. FIG. 1 is a perspective view illustrating a high frequency apparatus 100 or a printed board holding structure 100 according to the first embodiment of the present invention.

The high frequency apparatus 100 that is also the printed board holding structure 100 according to the first embodiment (simply referred to as the high frequency apparatus 100, hereinafter) includes a printed board 120 and a case 110 that holds the printed board 120. The case 110 has a shape of an approximately rectangular parallelepiped, and has a top plate 112 corresponding to one side of the rectangular parallelepiped and four side plates 111 respectively corresponding to four sides of the rectangular parallelepiped which are respectively perpendicular to the one side.

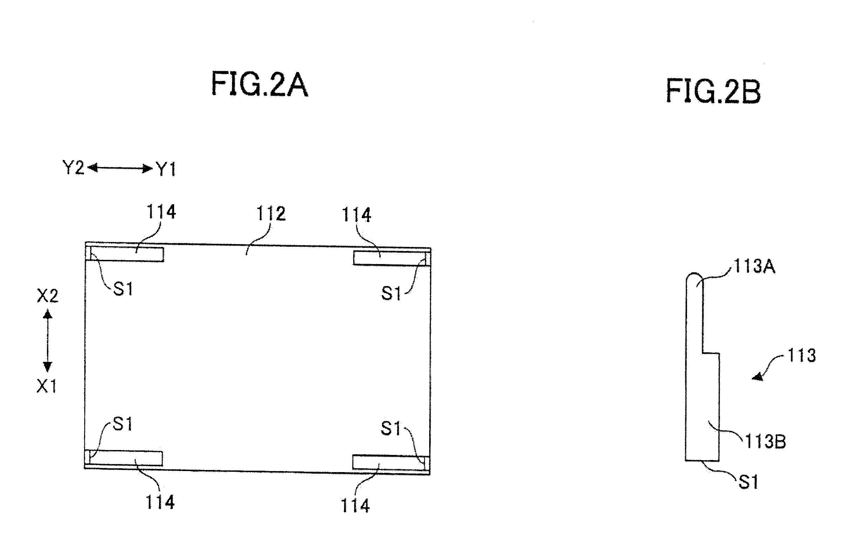

The printed board 120 held by the case 110 is covered by the four side plates 111 and the top plate 112 in X1, X2, Y1, Y2 and Z1 directions in FIG. 1, respectively. The case 110 in the present embodiment is made of a metal, and has a shielding function. The shielding function includes at least one of an electrostatic shielding function, a magnetic shielding function and an electromagnetic shielding function. It is noted that in FIG. 1 and FIG. 2A, the X1 and X2 directions, the Y1 and Y2 directions and the Z1 and Z2 directions respectively correspond to an X coordinate axis, a Y coordinate axis and a Z coordinate axis, perpendicular to each other, of an X-Y-Z coordinate system.

Near the four corners of the top plate 112 of the case 110, four engagement claws 113 are formed, respectively, to fix the printed board 120 and the case 110 together. Each of the four engagement claws 113 is bent toward the printed board 120 from the top plate 112, i.e., in the Z2 direction. Holes 114 are formed as a result of the engagement claws 113 being thus bent from the top plate 112.

That is, the respective engagement claws 113 are formed as follows. At each of respective positions near the four corners of the top plate 112, a predetermined area of the top plate 112, which area extends, for example, in the Y1 and Y2 directions (i.e., a longitudinal direction of the case 100), is defined. Then, the defined predetermined area of the top plate 112 is bent, for example, in the Z2 direction, around a boundary line S1 of the predetermined area. At this time, except the boundary line S1, the predetermined area is cut off from the top plate 112. The above-mentioned four holes 114 are formed as a result of the four predetermined areas being thus cut off, respectively. The boundary lines S1 of the respective predetermined areas correspond to ends of the respective predetermined areas adjacent to the side plates 111 facing the Y1 and Y2 directions, respectively, as shown in FIG. 1. The thus-bent predetermined area of the top plate 112 is then processed to have a shape of the engagement claw 113, for example, as that shown in FIG. 2B.

FIG. 2A shows a view taken from the Z1 direction in FIG. 1 and illustrates the high frequency apparatus in the first embodiment. FIG. 2B illustrates a shape of the engagement claw 113 provided from the top plate 112 of the case 110.

According to the first embodiment, each of the four engagement claws 113 has an extending end part 113A to be used for fixing the printed board 120 and the case 110 together. The extending end part 113A of each engagement claw 113 further extends from an extending end of a bending part 113B that extends from the boundary line S1. The extending end part 113A has a width smaller than a width of the bending part 113B, as shown in FIG. 2B. Each engagement claw 113 is formed as a result of the corresponding predetermined area of the top plate 112 being bent toward the printed board 120 (in the Z2 direction). The extending end parts 113A of the respective thus-formed four engagement claws 113 are respectively inserted into through holes 121 formed near the four corners of the printed board 120, respectively, as shown in FIG. 1. As a result, the four through holes 121 of the printed board 120 are engaged by the respective four extending end parts 113A of the four engagement claws. In the first embodiment, in this engaged state, the respective four extending end parts 113A of the four engagement claws 113 and the peripheries of the respective four through holes 121 of the printed board 120 are soldered and thus fixed together.

It is noted that the engagement claws 113 may extend not necessarily in the Z2 direction, and may extend in directions other than the Z2 direction. The point is as follows. The bending parts 113B of the engagement claws 113 may be bent so that the bending parts 113B of the engagement claws 113 extend in the inside of the case 110 and the extending end parts 113A are inserted into the through holes 121 of the printed board 120 that is disposed in the case 110. It is noted that the through holes 121 are formed in the printed board 120 in conformity with a design of the case 110.

It is noted that according to the first embodiment, the four holes 114, formed when the four predetermined areas of the top plate 112 are cut off and bent in the Z2 direction, for example, and the engagement claws 113 are formed, may be covered by plates or such made of the same metal as that of the case 110, respectively. Thereby, it is possible to further improve the shielding function of the case 110.

Thus, according to the first embodiment, it is possible to fix the printed board 120 and the case 110 together, without forming recesses 15 such as those toward the inside of the case 11 as in the related art described above with reference to FIG. 6. Further, according to the first embodiment, the four engagement claws 113 are formed as a result of the four predetermined areas of the top plate 112 being bent in the Z2 direction, for example, respectively. At this time, it is possible to form the engagement claws 113 from the top plate 112 in such a manner that the respective extending end parts 113A of the engagement claws 113 are disposed near the four corners of the printed board 120. By this configuration, it is possible to effectively use the dead spaces (i.e., spaces near the four corners) of the printed board 120, for fixing the printed board 120 and the case 110 together, such dead spaces of a printed board not being used in the configuration of the related art described above with reference to FIG. 6. Thus, according to the first embodiment, it is possible to make the positions at which the engagement claws 113 of the case 110 engage the printed board 120 coincide with the dead spaces near the four corners of the printed board 120; thus it is possible to effectively use the area of the printed board 120, and it is possible to contribute to miniaturization of the high frequency apparatus 100.

### (Second Embodiment)

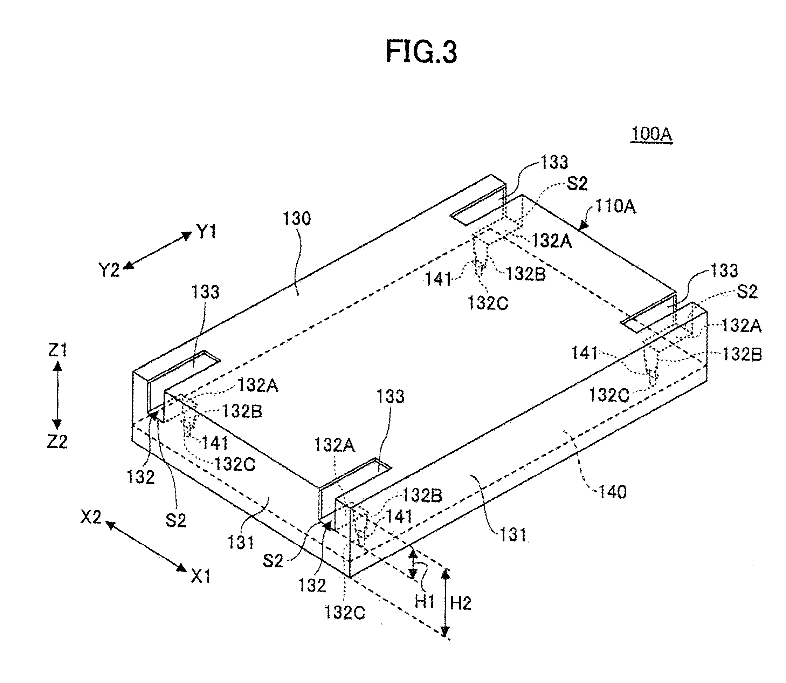

Bellow, with reference to figures, a second embodiment of the present invention will be described. FIG. 3 is a perspective view illustrating a high frequency apparatus 100A or a printed board holding structure 100A according to the first embodiment of the present invention.

In the high frequency apparatus 100A that is also the printed board holding structure 100A according to the second embodiment (simply referred to as the high frequency apparatus 100A, hereinafter), the same as the high frequency apparatus 100 according to the first embodiment described above, a printed board 140 is held by a case 110A. The case 110A has a shape of an approximately rectangular parallelepiped, and has a top plate 130 corresponding to one side of the rectangular parallelepiped and four side plates 131 respectively corresponding to four sides of the rectangular parallelepiped which are respectively perpendicular to the one side.

The printed board 140 held by the case 110A is covered by the four side plates 131 and the top plate 130 in X1, X2, Y1, Y2 and Z1 directions in FIG. 3, respectively. The case 110A in the present embodiment is also made of a metal, and has a shielding function. The shielding function includes at least one of a electrostatic shielding function, a magnetic shielding function and a electromagnetic shielding function. It is noted that in FIG. 3, FIGS. 4A, 4B and 4C, and FIGS. 5A and 5B, the X1 and X2 directions, the Y1 and Y2 directions and the Z1 and Z2 directions respectively correspond to an X coordinate axis, a Y coordinate axis and a Z coordinate axis, perpendicular to each other, of an X-Y-Z coordinate system.

In the case 110A of the high frequency apparatus according to the second embodiment, four engagement claws 132 are formed from the top plate 130 and two of the side plates 131 respectively facing the Y1 and Y2 directions in FIG. 3. Each of the four engagement claws 132 is cut off from the top plate 130 and the corresponding side plate 131, and bent in the inside of the case 110A. As a result of the four engagement claws 132 being thus formed, four holes 133 are formed in the case 110A on the two side plates 131 respectively facing the Y1 and Y2 directions through the top plate 130, as shown in FIG. 3.

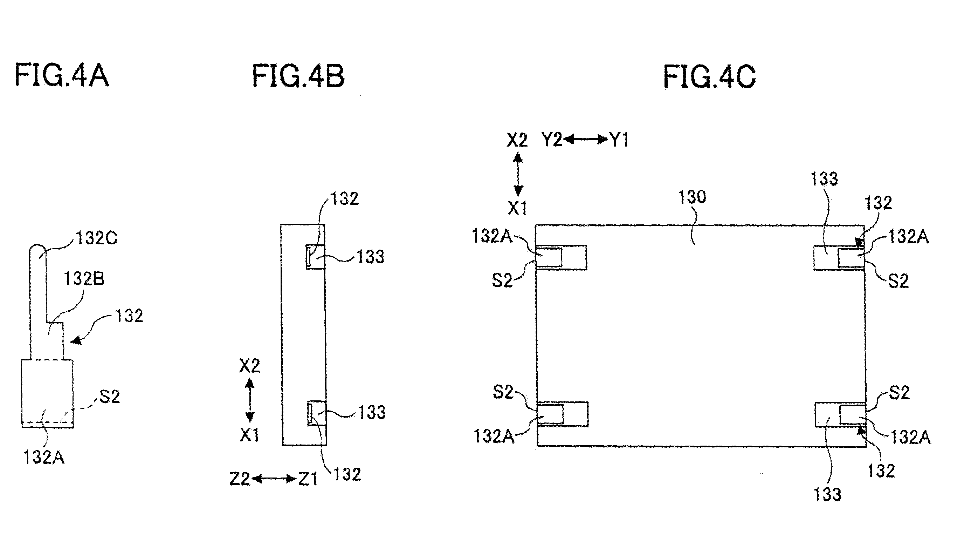

The respective engagement claws 132 are formed as follows. At respective positions near the four corners of the case 110A, four predetermined areas are defined on the two side plates 131 respectively facing the Y1 and Y2 directions through the top plate 130. The four predetermined areas respectively extend, for example, in the Z1 direction and then the Y1 and Y2 directions, respectively. Then, the defined four predetermined areas on the two side plates 131 and the top plate 130 are bent, respectively, toward the inside of the case 110A around respective boundary lines S2. At this time, except the respective boundary lines S2 of the four predetermined areas, the four predetermined areas are cut off from the top plate 130 and the two side plates 131, respectively. The above-mentioned four holes 133 are formed as a result of the four predetermined areas being thus cut off, respectively. The boundary lines S2 correspond to the respective ends in the Z2 direction of the four predetermined areas. Thus, the four engagement claws 132 are formed, as shown in FIG. 3. Further, each engagement claw 132 is processed to have a shape such as that shown in FIG. 4A.

FIGS. 4A, 4B and 4C illustrate the high frequency apparatus 100A according to the second embodiment. FIG. 4A is a developed view and illustrates the shape of the engagement claw 132. FIG. 4B is a view of the high frequency apparatus 100 taken from the Y2 direction of FIG. 3. FIG. 4C is a view of the high frequency apparatus 100 taken from the Z1 direction of FIG. 3.

As shown in FIG. 4A, each of the engagement claws 132 in the second embodiment has a bending part 132A that extends from the boundary line S2; a bending part 132B that further extends from the extending end of the bending part 132A and has a width smaller than a width of the bending part 132A; and an extending end part 132C that further extends from the extending end of the bending part 132B and has a width further smaller than the width of the bending part 132B. It is preferable that the bending part 132A is bent from the corresponding side plate 131 to extend in parallel with the top plate 130 toward the inside of the case 110A (for example, in the Y1 or Y2 direction). It is preferable that the bending part 132B is bent to extend approximately perpendicular to the bending part 132A, for example, in the Z2 direction.

As a result of the four engagement claws 132 being thus formed, as shown in FIG. 3, the respective extending end parts 132C of the four engagement claws 132 are inserted into respective through holes 141 formed in the printed board 140, and thus, pass through the printed board 140. Thus, the case 110A and the printed board 140 are joined together. According to the second embodiment, in this joined state, the respective extending end parts 132C of the four engagement claws 132 and the peripheries of the corresponding four through holes 141 of the printed board 140 are soldered and fixed together.

The bending parts 132A may extend not necessarily in parallel with the top plate 130, and may extend in directions other than parallel with the top plate 130. Further, the bending parts 132B may extend not necessarily perpendicular to the bending parts 132A, respectively, and may extend in directions other than perpendicular to the bending parts 132A, respectively. The point is as follows. The bending part 132A of each engagement part 132 may be bent to extend toward the inside of the case 110A; and the bending part 132B may be bent to extend toward the position at which the printed board 140 held in the inside of the case 110A is disposed so that the extending end part 132C is inserted into the corresponding through hole 141 of the printed board 140. It is noted that the through holes 141 are formed in the printed board 140 in conformity with a design of the case 110A.

As a result of the engagement claws 132 being thus bent in the inside of the case 110A, the four holes 133 are formed, also on the two side plates 131 respectively facing the Y1 and Y2 directions as shown in FIG. 4B. The four holes 133 are formed on these two side plates 131 through the top plate 130 as shown in FIG. 4C, respectively. That is, according to the second embodiment, the engagement claws 132 are formed by using the predetermined areas extending on the side plates 131 through the top plate 130 as mentioned above. As a result, it is possible that the holes 133 formed on the side plates 131 and the top plate 130 are reduced in size in comparison to the holes 114 formed on the top plate 112 in the first embodiment shown in FIGS. 1 and 2A. Therefore, it is possible to improve the shielding function of the case 110A in comparison to that of the case 110 of the first embodiment.

The reason why the holes 133 formed on the side plates 131 and the top plate 130 are reduced in size in comparison to the holes 114 formed on the top plate 112 in the first embodiment is as follows. That is, according to the first embodiment, the engagement claws 113 extend from the top plate 112 while according to the second embodiment, the engagement claws 132 extend from the side plates 131, respectively. As can be seen, the distance to the printed board is nearer from the side plate than from the top plate. Therefore, in comparison to the length of each engagement claw 113 extending from the top plate 112 to the printed board 120 in the first embodiment, the length of each engagement claw 132 extending from the respective one of the side plates 131 to the printed board 140 in the second embodiment can be made smaller. It is noted that as mentioned above, the engagement claws 113 are formed as a result of the top plate 112 being cut off according to the first embodiment, and the engagement claws 132 are formed as a result of the side plates 131 and the top plate 130 being cut off in the second embodiment. Therefore, the full length of each hole corresponds to the full length of the respective one of the engagement claws. Accordingly, in comparison to the first embodiment, the full length of each hole 133 can be made shorter in the second embodiment in which each engagement claw 132 can be made shorter. It is noted that if each through hole 141 of the printed board 140 is disposed away from the respective one of the side plates 131 from which the engagement claw 132 extends, each engagement claw 132 extending from the side plate 131 to the through hole 141 is to be elongated, and in this case, the full length of the hole 133 corresponding to the full length of the engagement claw 132 becomes longer. Therefor, in order to improve the shielding function of the case 110A, it is preferable that the through holes 141 are disposed near the edges of the printed board 140, respectively, so that the through holes 141 are disposed near the side plates 131 from which the engagement claws 132 extend, respectively, when the printed board 140 is disposed in the case 110A.

Further, in the second embodiment, it is assumed that each boundary line S2 between the corresponding bending part 132A of the engagement claw 132 and the corresponding side plate 131 of the case 110A exists at a distance H1 in the Z2 direction of FIG. 3 from the top plate 130. It is noted that at the boundary lines S2, the bending parts 132A are bent from the side plates 131, respectively. In this case, it is preferable that the distance H1 is equal to or less than H2/2 where H2 denotes a size of the case 110A in the Z1 and Z2 directions. Thereby, it is possible to prevent the bending parts 132A, formed as a result of the predetermined areas of the top plate 130 and the side plates 131 being bent in the inside of the case 110A, from coming into contact with the printed board 140 held in the case 110A as shown in FIG. 3.

Further, according to the second embodiment, even in a case where the through holes 141 are formed at any positions on the printed board 140, the extending end parts 132C of the engagement claws 132 can be made to be inserted into the through holes 141 formed on the printed board 140 when the printed board 140 is put in the inside of the case 110A, by adjusting the positions of the engagement claws 132. For example, according to the second embodiment, it is possible to adjust the positions at which the engagement claws 132 engages the printed board 140 by adjusting the above-mentioned distances H1 of the boundary lines S2 on the side plates 131 from the top plate 130; adjusting the positions in the X1 and X2 directions (see FIG. 3) at which the engagement claws 132 extend from the side plates 131; or so.

Thus, according to the second embodiment, it is also possible to form the through holes 141 on the printed board 140 at positions where circuit patterns and/or interconnection patterns of the electronic circuit are not formed, and form the engagement claws 132 in such a manner that the extending end parts 132C are inserted into the through holes 140. Thus, according to the second embodiment, it is possible to eliminate restrictions on positions at which the extending end parts 132C of the engagement claws 132 are disposed.

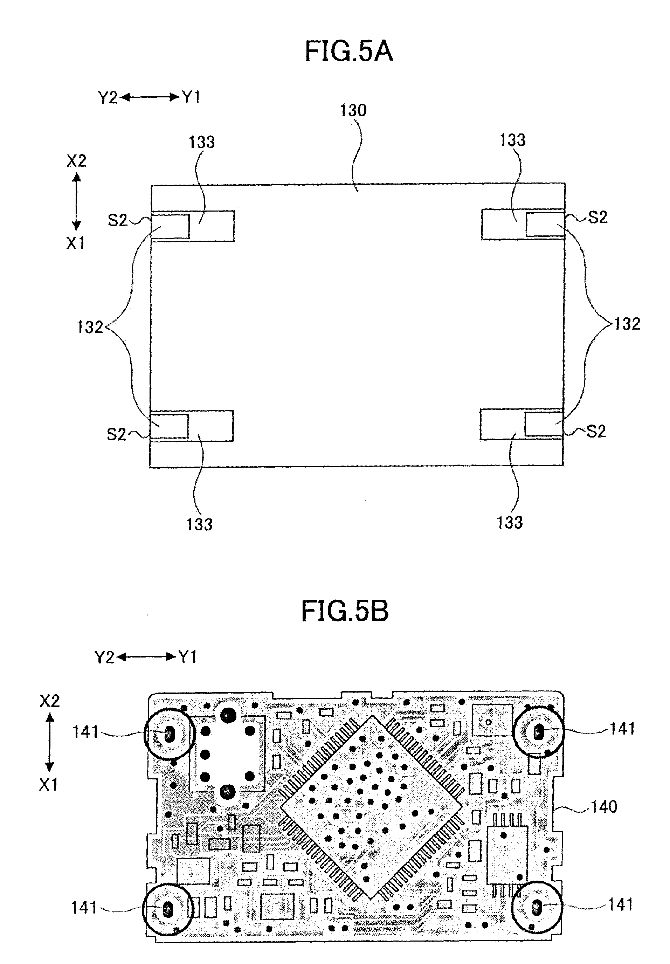

FIGS. 5A and 5B illustrate engagement between the case 110A and the printed board 140 in the high frequency apparatus according to the second embodiment. In the example of FIGS. 5A and 5B, the through holes 141 are formed near the four corners of the printed board 140, respectively. As mentioned above, the case 110A and the printed board 140 are engaged together as a result of the extending end parts 132C of the engagement claws 132 of the case 110A passing through the through holes 141, respectively.

It is noted that in the example described above with reference to FIGS. 3 through FIG. 5B, the four of the engagement claws 132 are provided in the case 110A and the four of the through holes 141 are provided in the printed board 140, correspondingly. However, the number or the engagement claws 132, i.e., the number of the through holes 141, is not limited to this example. That is, the number of the engagement claws 132, i.e., the number of the through holes 141, may be other than four, may be a number more than four or may be a number less than four.

Further, in the second embodiment, the boundary lines S2 between the case 110A and the engagement claws 132 exist on the side plates 131. However, it is also possible that the boundary lines between the case 110A and the engagement claws 132 may exist on the top plate 130 instead. In this case, the engagement claws may have shapes the same as those of the engagement claws 113 in the first embodiment described above with reference to FIGS. 1 through 2B. Further, in this case, the engagement claws may be formed as a result of the predetermined areas that extend on the top plate 130 through the two side plates 131 in the Y1 and Y2 directions and then the Z2 direction, as shown in FIG. 3 as the holes 133, being bent around the respective boundary lines existing on the top plate 130 toward the printed board 140 that is disposed in the case 110A.

Further in this case or in the first embodiment described above with reference to FIGS. 1 through 2B, the printed board 140 or 120 is held by the engagement claws that extend from the top plate 130 or 112 toward the printed board 140 or 120. Therefore, no structure is provided on the side plates 131 or 111 for holding the printed board 140 or 120, and thus, it is possible to contribute to making the high frequency apparatus 100A or 100 thinner.

Thus, according to the first embodiment or the second embodiment described above, it is possible to fix the printed board (120 or 140) and the case (110 or 110A) together by using the areas near the four corners of the printed board (120 or 140), which areas are not used in the related art described above with reference to FIG. 6. Thereby, it is possible to effectively use the space on the printed board (120 or 140), it is possible to contribute to miniaturization of the printed board (120 or 140), and also, it is possible to contribute to miniaturization of the high frequency apparatus (100 or 100A).

Further, the present invention is not limited to the above-described embodiments, and variations and modifications may be made without departing from the basic concept of the present invention.

The present application is based on Japanese Priority Application No. 2010-169283, filed July 28, 2010, the entire contents of which are hereby incorporated herein by reference.

## Claims

1. A high frequency apparatus comprising:
a printed board in which an electronic circuit is formed;
a case having a top plate and side plates, and holding the printed board;
an engagement claw formed by using a part of the top plate; and
a through hole formed in the printed board, an extending end part of the engagement claw being inserted into the through, hole and passing through the printed board, wherein
the engagement claw and the through hole are fixed together by using a solder.

2. The high frequency apparatus as claimed in claim 1, wherein
the engagement claw is formed by using also a part of the side plate.

3. The high frequency apparatus as claimed in claim 2, wherein
the engagement claw includes
a first bending part that is bent from the side plate toward the inside of the case; and
a second bending part that is bent toward the printed board in such a manner that the extending end part is inserted into the through hole formed in the printed board.

4. The high frequency apparatus as claimed in claim 3, wherein
a distance of the first bending part from the top plate in a direction perpendicular to the top plate is equal to or less than 1/2 of a size of the case in the direction perpendicular to the top plate.

5. The high frequency apparatus as claimed in any one of claims 1-4,
comprising at least four of the engagement claws, the four engagement claws being provided near the four corners of the top plate, wherein
the four engagement claws are formed as a result of defining four areas that respectively extend in two of the side plates facing one another through the top plate, and bending the four areas toward the inside of the case around respective ends of the four areas.

6. The high frequency apparatus as claimed in claim 1, wherein
the engagement claw is formed as a result of a predetermined area of the top plate being bent toward the printed board.

7. The high frequency apparatus as claimed in claim 1 or 6,
comprising at least four of the engagement claws, the four engagement claws being provided near the four corners of the top plate, wherein
the four engagement claws are formed as a result of defining four areas that respectively extend in the top plate in a longitudinal direction of the top plate, and bending the four areas toward the inside of the case around respective ends of the four areas.

8. A printed board holding structure comprising:
a printed board in which an electronic circuit is formed;
a case having a top plate and side plates, and holding the printed board;
an engagement claw formed by using a part of the top plate; and
a through hole formed in the printed board, an extending end part of the engagement claw being inserted into the through hole and passing through the printed board, wherein
the engagement claw and the through hole are: fixed together by using a solder.

9. The printed board holding structure as claimed in claim 8, wherein
the engagement claw is formed also by using a part of the side plate.

10. The printed board holding structure as claimed in claim 9, wherein
the engagement claw includes
a first bending part that is bent from the side plate toward the inside of the case; and
a second bending part that is bent toward the printed board in such a manner that the extending end part is inserted into the through hole formed in the printed board.

11. The printed board holding structure as claimed in claim 10, wherein
a distance of the first bending part from the top plate in a direction perpendicular to the top plate is equal to or less than 1/2 of a size of the case in the direction perpendicular to the top plate.

12. The printed board holding structure as claimed in any one of claims 8-11,
comprising at least four of the engagement claws, the four engagement claws being provided near the four corners of the top plate, wherein
the four engagement claws are formed as a result of defining four areas that respectively extend in two of the side plates facing one another through the top plate, and bending the four areas toward the inside of the case around respective ends of the four areas.

13. The printed board holding structure as claimed in claim 8, wherein
the engagement claw is formed as a result of a predetermined area of the top plate being bent toward the printed board.

14. The printed board holding structure as claimed in claim 8 or 13,
comprising at least four of the engagement claws, the four engagement claws being provided near the four corners of the top plate, wherein
the four engagement claws are formed as a result of defining four areas that respectively extend in the top plate in a longitudinal direction of the top plate, and bending the four areas toward the inside of the case around respective ends of the four areas.
